# EUROPÄISCHE PATENTSCHRIFT

(11) **EP 0 613 053 B1**
(45) Veröffentlichungstag und Bekanntmachung des Hinweises auf die Patenterteilung: **05.04.2000**
(21) Anmeldenummer: 94100278.4
(22) Anmeldetag: 11.01.1994
(51) Int. Cl.: G03F 7/42, C08J 11/08

(54) **Verfahren zum Beseitigen von Kunststoffen aus Mikrostrukturen**
Process for removing plastics from microstructures
Procédé pour éliminer des matières plastiques de microstructures

(30) Priorität: 10.02.1993 DE 4303923
(43) Veröffentlichungstag der Anmeldung: 31.08.1994
(73) Patentinhaber: microParts Gesellschaft für Mikrostrukturtechnik mbH, 44227 Dortmund (DE)
(72) Erfinder: Reinecke, Holger, Dr., D-44287 Dortmund (DE)

(56) Entgegenhaltungen:
- EP-A- 0 219 789
- EP-A- 0 485 161
- WO-A-91/17484
- DE-A- 1 621 664
- FR-A- 2 291 607
- GB-A- 2 173 918
- US-A- 3 873 361
- US-A- 4 165 294
- IBM TECHNICAL DISCLOSURE BULLETIN page 6588, vol. 25, no. 12, May 1983 MIGLIORE M.J. 'Butyrolactone as a Stripping Solvent in Lift-off Process'

## Beschreibung

Die Erfindung betrifft ein Verfahren zum Beseitigen von Kunststoffen aus Mikrostrukturen, speziell mit großem Aspektverhältnis. Derartige Strukturen haben Strukturtiefen von einigen Mikrometern bis in den Bereich von Millimetern bei lateralen Abmessungen im Mikrometerbereich.

Die Erfindung bezweckt, das Beseitigen von Kunststoffen aus Mikrostrukturen zweckmäßiger und wirtschaftlicher zu gestalten.

Mikrostrukturen können nach verschiedenen Verfahren hergestellt werden, z. B. mit dem LIGA-Verfahren, oder durch mikromechanische Präzisionsbearbeitung. Das LIGA-Verfahren umfaßt die Verfahrensschritte Lithographie, Galvanoformung und Abformung; damit lassen sich große Stückzahlen von Mikrostrukturen präzise fertigen.

Beim Fertigungsschritt Lithographie, bevorzugt als Röntgen-Tiefenlithographie, wird als strahlungsempfindlicher Resist z. B. Polymethylmethacrylat (PMMA) eingesetzt, welches bevorzugt vernetzt wird. Im Vergleich zu unvernetztem PMMA haftet vernetztes PMMA besser auf dem Substrat, es ist formstabiler und hat günstigere mechanische Eigenschaften sowie eine höhere Selektivität beim Entwickeln.

Bei der Galvanoformung wird in den durch Lithographie und Entwicklung erzeugten Primärstrukturen ein Metall oder eine Legierung galvanisch abgeschieden. Der formgebende Kunststoff, z. B. vernetztes PMMA, wird anschließend aus der metallischen Mikrostruktur entfernt. Dieser Verfahrensschritt ist die Entschichtung.

Es ist bekannt, bei schwerlöslichen formgebenden Kunststoffen aggressive chemische Lösemittel zum Entschichten einzusetzen; dabei muß jedoch die chemische Veränderung der metallischen Mikrostrukturen, die z. B. aus Kupfer, Nickel, Nickel/Kobalt-Legierung oder Gold bestehen können, vermieden werden. Beim Fluorieren des schwerlöslichen formgebenden Kunststoffs, z. B. mit kochender Trifluoressigsäure, und anschließendem Lösen in einer Mischung aus Aceton und Salzsäure quillt der Kunststoff, wodurch die metallische Mikrostruktur beschädigt oder zerstört wird.

Es ist vorgeschlagen worden (IBM Technical Disclosure Bulletin 25 (1983), Seite 6588), bei metallischen Halbleiterstrukturen den strukturierten Photoresist mittels γ-Butyrolacton bei 140 °C zu entfernen. Bei diesem Verfahren quillt der strukturierte Photoresist, wodurch die auf dem Photoresist abgeschiedenen Bereiche der Metallschicht von den auf dem Untergrund haftenden Bereichen des strukturierten Photoresists abgerissen werden. Wegen dieses Quellvorganges kann dieses Verfahren nur bei Mikrostrukturen mit einem Aspektverhältnis unter 1 angewendet werden.

In US - 4 165 294 werden Entschichtungslösungen angegeben, die aus oberflächenaktiven Alkylarylsulfonsäuren, aromatischen Sulfonsäuren sowie gegebenenfalls einem halogenfreien aromatischen Kohlenwasserstoff bestehen und frei von Phenol, Phenolderivaten und chlorierten Kohlenwasserstoffen sind. Diese Lösungen werden zum Entfernen von Photolacken, wie Polyisopren, Polyvinyl-Cinnamat und Phenol-Formaldehyd-Harz, von anorganischen Substraten verwendet. Die Behandlungstemperatur beträgt etwa 50 °C bis 180 °C, bevorzugt 90 °C bis 120 °C. Eine schwerlösliche Photolack-Schicht wird als Schicht von Substrat abgelöst und schwimmt in der Lösung. Dieser Vorgang verläuft nur bei mikrostrukturierten Substraten mit einem Aspektverhältnis unter 1 zufriedenstellend.

Gemäß DE - 1621664 wird ein Gemisch aus halogenierten Karbonsäuren (z.B. Mono/di/trichloressigsäure) und aromatischen Kohlenwasserstoffen (z.B. Xylol oder Toluol) z.B. bei 140 °C zum Ablösen eines Photolacks verwendet. Derartige Gemische führen zum Quellen des Photolacks und greifen Metalle teilweise stark an.

Aus EP - 0 455 161 sind Entschichtungsmittel bekannt, die aus Hydroxylamin und mindestens einem Alkanolamin bestehen; gegebenenfalls wird eine polare Flüssigkeit, wie N-Methyl-2-Pyrrolidon, Dialkylenglycol-alkylether, Triethylenglycol-butylether oder Diethylentriamin zugegeben. Derartige Entschichtungsmittel sind geeignet zum Abziehen von Photolack bei der Herstellung von Halbleiter-Schaltkreisen und zum Abziehen von ausgehärteten Polymerbeschichtungen. Die Temperatur beim Entschichten liegt zwischen 50 °C und 150 °C, bevorzugt bei 65 °C bis 75 °C. Die Photolack-Schichten sind wenige Mikrometer dick. Das Apektverhältnis derartiger Mikrostrukturen liegt bekanntermaßen unterhalb 1. Derartige Entschichtungsmittel können z.B. Aluminium korrodieren.

Weiter ist bekannt, den formgebenden Kunststoff nach der Galvanoformung erneut flutlichtartig zu bestrahlen und dadurch dessen Löslichkeit zu erhöhen; hierzu ist Synchrotron-Strahlung, Röntgen-Strahlung oder Laser-Strahlung erforderlich. Dieses Verfahren ist aufwendig. Bei mäßig großer Strahlungsleistung ist dieser Verfahrensschritt zeitraubend; die metallische Mikrostruktur bleibt dabei jedoch unverändert. Bei großer Strahlungsleistung, z. B. hochenergetischer Synchrotron-Strahlung, ist zwar die Bestrahlungszeit kurzer, jedoch wird dabei die Oberfläche der metallischen Mikrostruktur verändert. Dadurch bedingte Qualitätseinbußen erfordern gegebenenfalls ein aufwendiges Nacharbeiten der Mikrostruktur. Während des Bestrahlens lassen sich die metallischen Mikrostrukturen zwar durch Masken oder durch Inertgas abdecken, was jedoch apparativ und fertigungstechnisch aufwendig ist.

Weiterhin ist bekannt, den formgebenden Kunststoff bei hohen Temperaturen oder/und im Plasma zu beseitigen. Dabei kommt es jedoch im allgemeinen zu Veränderungen der Eigenschaften wie Härte, Elastizitätsmodul, u. a., der Metalle oder Legierungen der Mikrostrukturkörper oder es findet eine bereichsweise vollständige Zerstörung der Mikrostrukturkörper oder chemische Reaktion zwischen dem Metall der Mikrostrukturkörper und dem Polymer oder der umgebenden Atmosphäre statt.

Mit Hilfe der metallischen Mikrostruktur werden z. B. durch Spritzgießen, Reaktionsgießen oder Warmformen Mikrostrukturkörper aus Kunststoff in großer Stückzahl abgeformt. Beim Herausziehen des Mikrostrukturkörpers aus Kunststoff kann - im Störungsfall - der Kunststoff in der metallischen Mikrostruktur (teilweise) hängenbleiben. Auch in diesem Fall ist der Kunststoff aus der metallischen Mikrostruktur herauszulösen, damit man die metallische Mikrostruktur erneut verwenden kann. Für thermoplastische Kunststoffe, vor allem für amorphe Kunststoffe, sind geeignete Lösemittel bekannt. Teilkristalline Kunststoffe sind oft erst bei höheren Temperaturen löslich. Problematisch sind auch in diesem Fall duroplastische vernetzte Kunststoffe, für die meist keine geeigneten Lösemittel bekannt sind oder bekannte Lösemittel die metallische Mikrostruktur angreifen.

Wegen der Schwierigkeiten beim Entschichten werden duroplastische Kunststoffe - wie vernetztes PMMA - sowie Epoxidharze, Silikonkautschuk und andere Kunststoffe zum Abformen kaum eingesetzt. Andererseits sind derartige Kunststoffe aus anwendungstechnischen Gründen oft gefragt, da sie sich durch thermische und chemische Beständigkeit auszeichnen.

Damit stellt sich die Aufgabe, ein Verfahren zu finden, mit dem man - auch schwerlösliche - Kunststoffe aus metallischen Mikrostrukturen auf einfache Weise beseitigen kann, ohne die Qualität der metallischen Mikrostrukturen zu beeinträchtigen.

Diese Aufgabe wird erfindungsgemäß gelöst durch ein Verfahren, bei dem der metallische Mikrostrukturkörper mit einem den Kunstsoff nicht quellenden ((4 mal)) Fluid, dessen Siedetemperatur (bei Normaldruck) größer ist als 130 °C, bei einer Temperatur oberhalb 140 °C behandelt wird.

Zum Beseitigen von schmelzbaren Kunststoffen aus einem metallischen Mikrostrukturkörper wird dieser Körper mit einem den Kunstsoff nicht quellenden ((4 mal)) Fluid bei einer Temperatur behandelt, die in einem Bereich von 20 Grad unterhalb bis 100 Grad oberhalb der Schmelztemperatur des Kunststoffes liegt und gleichzeitig in einem Bereich von 50 Grad unterhalb bis zur Siedetemperatur des Fluids.

Zum Beseitigen von nicht schmelzbaren Kunststoffen aus einem metallischen Mikrostrukturkörper wird dieser Körper mit einem den Kunstsoff nicht quellenden ((4 mal)) Fluid bei einer Temperatur oberhalb 140 °C behandelt.

Der Mikrostrukturkörper kann sich während des Behandelns mit einem den Kunstsoff nicht quellenden ((4 mal)) Fluid entweder in der Flüssigphase oder in der Dampfphase des Fluids befinden. Das Fluid kann unter erhöhtem Druck stehen.

Es ist zweckmäßig, beim Behandeln des metallischen Mikrostrukturkörpers in der Flüssigphase des Fluids gleichzeitig mechanische Energie zuzuführen, z. B. durch Rühren, Ultraschall oder Megaschall. Als Fluide sind hochsiedende Flüssigkeiten geeignet, bevorzugt Ethylenglykol, sowie dessen Oligomere, Polymere oder Derivate, Propandiol, Butandiol, Ester von Dicarbonsäuren, Silikonöl oder Polyvinylalkohol. Dem Fluid können Metallsalze, wie Zinkbromid, Kobaltbromid, Silberazetat oder Radikalbildner, wie Chlornitrosobenzol, Benzoylperoxid oder Bisazoisobutyronitril zugegeben werden.

Zum Beseitigen von vernetztem PMMA aus einem metallischen Mikrostrukturkörper wird dieser z. B. mit Polyethylenglykol 400 oberhalb 180 °C, bevorzugt bei 220 °C bis 240 °C, behandelt. Zum Beseitigen von Polyoxymethylen aus einem metallischen Mikrostrukturkörper wird dieser z. B. mit Diethylenglykol-monobutylether bei 190 °C behandelt.

Das erfindungsgemäße Verfahren hat folgende Vorteile:
- Beim Herstellen der metallischen Mikrostrukturen durch Lithographie können Kunststoffe eingesetzt werden, die sonst - ohne Anwendung des erfindungsgemäßen Verfahrens - wegen ihres Verhaltens beim Entschichten gar nicht oder nur bedingt brauchbar sind.
- Beim Abformen eines Mikrostrukturkörpers aus Kunststoff mittels einer metallischen Mikrostruktur können Kunststoffe verwendet werden, die bisher wegen der Probleme beim Beseitigen von Kunststoffresten aus der Mikrostruktur gar nicht oder nur bedingt brauchbar sind.
- Die Qualität der entschichteten metallischen Mikrostrukturen und ihre Gebrauchsdauer ist deutlich höher als bisher.
- Das Entschichten der metallischen Mikrostrukturen ist erheblich einfacher und wirtschaftlicher als bei Anwendung der bisher bekannten Verfahren.
- Der zu beseitigende Kunststoff quillt in den angegebenen Fluiden praktisch gar nicht; dadurch wird das Risiko, die Mikrostruktur zu zerstören, gemindert.
- Die angegebenen Fluide sind gesundheitlich und verfahrensseitig unbedenklich und preisgünstig. Sie sind überwiegend in jedem Verhältnis mit Wasser mischbar. Sie greifen die metallische Mikrostruktur nicht an.
- Die im Fluid enthaltenen Reste des Kunststoffes fällen auch beim Erkalten des Fluids nicht aus.
- Die mit dem Fluid behandelten Mikrostrukturen werden anschließend lediglich mit vollentsalztem Wasser abgespült.
- Kritische Temperaturen, die zu Veränderungen der Materialeigenschaften der Mikrostrukturkörper führen, werden vermieden.
- Die zum Beseitigen der Kunststoffe benutzten Fluide sind ohne Probleme zu entsorgen.

Das erfindungsgemäße Verfahren wird an Hand der folgenden Beispiele weiter erläutert.

### Beispiel 1: Entschichten einer Mikrostruktur in vernetztem PMMA mittels Polyethylenglykol

Eine 135 µm hohe metallische Mikrostruktur aus Kupfer, die in vernetztes PMMA (Plexit 60, Fa. Röhm, Darmstadt) mit einer kleinsten Breite von 5 µm eingeschlossen ist, wird in Polyethylenglykol 400 (Fa. Merck, Darmstadt) bei 230 °C in einem abgedeckten Gefäß behandelt. Nach 65 Minuten ist die Mikrostruktur vollständig entschichtet.

Die metallische Mikrostruktur zeigt keinerlei Strukturveränderungen und keine Veränderungen in der Kupferoberfläche.

### Beispiel 2: Entschichten einer Mikrostruktur in Epoxidharz mittels Dibutylsuccinat und Silberacetat

Eine metallische Mikrostruktur, bestehend aus Mikropyramiden mit einer Höhe größer als 600 µm aus einer Nickel/Kobalt-Legierung, die in Epoxidharz eingeschlossen ist, wird in Dibutylsuccinat mit Zusatz von 100 Milligramm Silberacetat pro Liter bei 210 °C in einem abgedeckten Gefäß behandelt. Nach 60 Minuten ist die Mikrostruktur vollständig entschichtet.

Die metallische Mikrostruktur zeigt keinerlei Strukturveränderungen und keine Veränderungen in der Metalloberfläche.

### Beispiel 3: Reinigen einer Mikrostruktur mittels Diethylenglykol-monobutylether

Eine 200 µm hohe metallische Mikrostruktur aus Nickel mit lateralen Abmessungen von 50 µm und einer kleinsten Breite von 8 µm zwischen zwei Wänden war zum Abformen von etwa 30 Mikrostrukturkörpern aus Polyoxymethylen benutzt und dabei durch Reste des Kunststoffs verunreinigt worden.

Diese Struktur wird mit Diethylenglykol-monobutylether bei 190 °C in einem abgedeckten Gefäßt gereinigt. Nach 15 Minuten ist diese Mikrostruktur vollständig frei von Kunststoffresten.

Die metallische Mikrostruktur zeigt keinerlei Strukturveränderungen und keine Veränderungen der Nickeloberfläche.

## Patentansprüche

1. Verfahren zum Beseitigen von Kunststoffen aus einem metallischen Mikrostrukturkörper, gekennzeichnet durch
- Behandeln des metallischen Mikrostrukturkörpers mit einem den Kunststoff nicht quellenden Fluid, dessen Siedetemperatur (bei Normaldruck) größer ist als 130 °C, bei einer Temperatur oberhalb 140 °C.

2. Verfahren nach Anspruch 1 zum Beseitigen von schmelzbaren Kunststoffen aus einem metallischen Mikrostrukturkörper, gekennzeichnet durch
- Behandeln des metallischen Mikrostrukturkörpers mit einem den Kunststoff nicht quellenden Fluid bei einer Temperatur, die
- in einem Bereich von 20 Grad unterhalb bis 100 Grad oberhalb der Schmelztemperatur des Kunststoffs liegt und
- gleichzeitig in einem Bereich von 50 Grad unterhalb der Siedetemperatur bis zur Siedetemperatur des Fluids.

3. Verfahren nach Anspruch 1 zum Beseitigen von nicht schmelzbaren Kunststoffen aus einem metallischen Mikrostrukturkörper, gekennzeichnet durch
- Behandeln des metallischen Mikrostrukturkörpers mit einem den Kunststoff nicht quellenden Fluid bei einer Temperatur oberhalb 140 °C.

4. Verfahren nach den Ansprüchen 1 bis 3, gekennzeichnet durch
- Behandeln des metallischen Mikrostrukturkörpers in der Flüssigphase oder der Dampfphase des den Kunststoff nicht quellenden Fluids, gegebenenfalls unter erhöhtem Druck.

5. Verfahren nach den Ansprüchen 1 bis 4, gekennzeichnet durch
- Behandeln des metallischen Mikrostrukturkörpers in der Flüssigphase des den Kunststoff nicht quellenden Fluids bei gleichzeitigem Zuführen von mechanischer Energie, wie durch Rühren, Ultraschall, Megaschall.

6. Verfahren nach den Ansprüchen 1 bis 5, gekennzeichnet durch
- Behandeln des metallischen Mikrostrukturkörpers mit einem hochsiedenden den Kunststoff nicht quellenden Fluid, bevorzugt Ethylenglykol sowie dessen Oligomere, Polymere oder Derivate, Propandiol, Butandiol, Ester einer Dicarbonsäure, Polyvinylalkohol oder Silikonöl.

7. Verfahren nach den Ansprüchen 1 bis 6, gekennzeichnet durch
- Behandeln des metallischen Mikrostrukturkörpers mit einem den Kunststoff nicht quellenden Fluid unter Zusatz von
- Metallsalzen, wie Zinkbromid, Kobaltbromid, Silberazetat, oder
- Radikalbildnern, wie Chlornitrosobenzol, Benzoylperoxid, Bisazoisobutylnitril.

8. Verfahren nach den Ansprüchen 1 und 3 bis 7 zum Beseitigen von vernetztem Polymethylmethacrylat aus einem metallischen Mikrostrukturkörper, gekennzeichnet durch
- Behandeln des metallischen Mikrostrukturkörpers mit Polyethylenglykol oberhalb 160 °C, bevorzugt bei 210 °C bis 240 °C.

9. Verfahren nach den Ansprüchen 1 bis 2 und 4 bis 7 zum Beseitigen von Polyoxymethylen aus einem metallischen Mikrostrukturkörper, gekennzeichnet durch
- Behandeln des metallischen Mikrostrukturkörpers mit Diethylenglykolmonobutylether bei 190 °C.

## Claims

1. A process for removing plastics material from a metallic microstructure element, characterised by
- treatment of the metallic microstructure element at a temperature above 140°C with a fluid which does not swell the plastics material and whose boiling point (at atmospheric pressure) is above 130°C.

2. A process according to claim 1 for removing fusible plastics material from a metallic microstructure element, characterised by
- treatment of the metallic microstructure element with a fluid which does not swell the plastics material, the treatment being performed at a temperature which
- is in the range from 20 degrees below to 100 degrees above the melting point of the plastics material and
- simultaneously in the range from 50 degrees below the boiling point to the boiling point of the fluid.

3. A process according to claim 1 for removing infusible plastics material from a metallic microstructure element, characterised by
- treatment of the metallic microstructure element at a temperature above 140°C with a fluid which does not swell the plastics material.

4. A process according to any of claims 1 to 3, characterised by
- treatment of the metallic microstructure element in the liquid phase or the vapour phase of the fluid which does not swell the plastics material, optionally at superatmospheric pressure.

5. A process according to any of claims 1 to 4, characterised by
- treatment of the metallic microstructure element in the liquid phase of the fluid which does not swell the plastics material with simultaneous input of mechanical energy, such as by stirring, ultrasound or megasound.

6. A process according to any of claims 1 to 5, characterised by
- treatment of the metallic microstructure element with a high-boiling fluid which does not swell the plastics material, preferably ethylene glycol or an oligomer, polymer or derivative thereof, propanediol, butanediol, an ester of a dicarboxylic acid, polyvinyl alcohol or silicone oil.

7. A process according to any of claims 1 to 6, characterised by
- treatment of the metallic microstructure element with a fluid which does not swell the plastics material, with addition of
- metal salt, such as zinc bromide, cobalt bromide or silver acetate, or
- free - radical former, such as chloronitrosobenzene, benzoyl peroxide or bisazoisobutyronitrile.

8. A process according to any of claims 1 and 3 to 7 for removing crosslinked polymethyl methacrylate from a metallic microstructure element, characterised by
- treatment of the metallic microstructure element with polyethylene glycol at above 160°C, preferably at from 210°C to 240°C.

9. A process according to any claims 1, 2 and 4 to 7, for removing polyoxymethylene from a metallic microstructure element, characterised by
- treatment of the metallic microstructure element with diethylene glycol monobutyl ether at 190°C.

## Revendications

1. Procédé d'élimination de matières plastiques d'un solide à microstructure métallique,
caractérisé en ce qu'
on traite le solide à microstructure métallique à une température au-dessus de 140°C avec un fluide qui ne fait pas gonfler la matière plastique dont la température d'ébullition (à pression normale) est supérieure à 130°C.

2. Procédé selon la revendication 1 d'élimination de matières plastiques fusibles d'un solide à microstructure métallique,
caractérisé en ce qu'
on traite le solide à microstructure métallique avec un fluide qui ne fait pas gonfler la matière plastique à une température située
- dans une plage allant de 20°C en dessous à 100°C audessus de la température de fusion de la matière plastique, et
- en même temps dans une plage comprise entre 50°C en dessous de la température d'ébullition, et la température d'ébullition du fluide.

3. Procédé selon la revendication 1, d'élimination de matières plastiques non fusibles, d'un solide à microstructure métallique,
caractérisé en ce qu'
on traite le solide à microstructure métallique avec un fluide qui ne fait pas gonfler la matière plastique, à une température au-dessus de 140°C.

4. Procédé selon les revendications 1 a 3,
caractérisé en ce qu'
on traite le solide à microstructure métallique dans la phase liquide ou dans la phase vapeur du fluide qui ne fait pas gonfler la matière plastique, le cas échéant sous pression accrue.

5. Procédé selon les revendications 1 à 4,
caractérisé en ce qu'
on traite le solide à microstructure métallique dans la phase liquide du fluide qui ne fait pas gonfler la matière plastique, avec amenée simultanée d'énergie mécanique, comme par agitation, ultrasons ou mégasons.

6. Procédé selon les revendications 1 à 5,
caractérisé en ce qu'
on traite le solide à microstructure métallique avec un fluide à point d'ébullition élevé qui ne fait pas gonfler la matière plastique, de préférence l'éthylèneglycol, ainsi que ses oligomères, ses polymères ou ses dérivés, le propanediol, le butanediol, les esters d'un acide dicarboxylique, l'alcool polyvinylique ou une huile de silicone.

7. Procédé selon les revendications 1 à 6,
caractérisé en ce qu'
on traite le solide à microstructure métallique avec un fluide qui ne fait pas gonfler la matière plastique tout en ajoutant :
- des sels métalliques comme le bromure de zinc, le bromure de cobalt, l'acétate d'argent, ou
- des formateurs de radicaux comme le chloronitrosobenzène, le peroxyde de benzoyle et le bisazoisobutylnitrile.

8. Procédé selon les revendications 1 et 3 à 7 d'élimination de polyméthacrylate réticulé d'un solide à microstructure métallique,
caractérisé en ce qu'
on traite le solide à microstructure métallique avec du polyéthylèneglycol au-dessus de 160°C, de préférence de 210 à 240°C.

9. Procédé selon les revendications 1 à 2 et 4 à 7 pour l'élimination du polyoxyméthylène d'un solide à microstructure métallique,
caractérisé en ce qu'
on traite le solide à microstructure métallique avec de l'éther monobutylique de diéthylèneglycol à 190°C.
